Europäisches Patentamt

(19) European Patent Office

Office européen des brevets

(11) Numéro de publication : **0 128 798**
**B1**

(12) **FASCICULE DE BREVET EUROPÉEN**

(45) Date de publication du fascicule du brevet :
04.05.88

(21) Numéro de dépôt : 84401026.4

(22) Date de dépôt : 18.05.84

(51) Int. Cl.⁴ : **H 03 H   2/00**

(54) **Dispositif sélectif accordable à ondes magnétostatiques de volume.**

(30) Priorité : 27.05.83 FR 8308829

(43) Date de publication de la demande :
**19.12.84 Bulletin 84/51**

(45) Mention de la délivrance du brevet :
**04.05.88 Bulletin 88/18**

(84) Etats contractants désignés :
**DE GB NL**

(56) Documents cités :
**ELECTRONICS INTERNATIONAL, vol. 56, no. 1, janvier 1983, pages 85-86, New York, US; R.T. GAL-LAGHER: "Planar technology readies challenge to YIG spheres"**
**1979 IEEE MTT-S INTERNATIONAL MICROWAVE SYMPOSIUM DIGEST, pages 157-159, IEEE, New York, US; J.P. C ASTERA: "Magnetostatic volume wave resonators"**
**1979 INTERNATIONAL SYMPOSIUM ON CIRCUITS AND SYSTEMS PROCEEDINGS, pages 568-571, 17-19 juillet 1979, Tokyo, JP;J.M. OWENS et al.: "Surface acoustic wave and magnetostatic wave devices: a status report"**
**1983 IEEE MTT-S INTERNATIONAL MICROWAVE SYMPOSIUM DIGEST, 31 mai - 3 juin 1983, Boston, Massachusetts, pages 318-322, IEEE, New York, US; J.P. CASTERA et al.: "A tunable magnetostatic volume wave oscillator"**

(73) Titulaire : **THOMSON-CSF**
**173, Boulevard Haussmann**
**F-75379 Paris Cédex 08 (FR)**

(72) Inventeur : **Castera, Jean-Paul**
**THOMSON-CSF SCPI 173, bld Haussmann**
**F-75379 Paris Cedex 08 (FR)**

(74) Mandataire : **Lepercque, Jean et al**
**THOMSON-CSF SCPI 19, avenue de Messine**
**F-75008 Paris (FR)**

### Description

La présente invention se rapporte aux dispositifs sélectifs accordables basés sur l'émission et la réception d'ondes magnétostatiques de volume progressives. Ces ondes sont généralement propagées par une couche magnétique déposée sur un substrat non magnétique. Les caractéristiques sélectives sont obtenues en formant à la surface de la couche magnétique des cavités résonnantes délimitées par des réseaux de sillons ou de régions filamentaires ayant subi une implantation ionique. Le couplage ondulatoire en cascade de deux cavités résonnantes munies chacune d'un microruban permet de transmettre sélectivement un signal électrique à haute fréquence dans une plage de fréquence très étroite. On peut déplacer cette plage pour réaliser un accord en jouant sur l'intensité d'un champ magnétique de direction perpendiculaire au plan de la couche magnétique.

Les ondes magnétostatiques de volume progressives ont des caractéristiques de propagation isotropes dans le plan de la couche magnétique et par rapport aux ondes magnétostatiques de surface elles offrent l'avantage d'un niveau de saturation plus élevé. Si l'on s'avise de réaliser un dispositif sélectif accordable en plaçant dans une cavité résonnante un microruban émetteur et un microruban récepteur, on obtient bien une pointe de résonance à une fréquence donnée, mais le couplage direct qui s'établit entre les microrubans fait que les pertes d'insertion observées au voisinage de la résonance sont à peine plus importantes que celles que l'on observe au sommet de la pointe de résonance.

En disposant en cascade deux cavités résonnantes délimitées par des réseaux réflecteurs parallèles et équipées chacune d'un microruban, on peut isoler par filtrage un mode commun, afin qu'une seule pointe de résonance soit observée dans un intervalle de fréquences important. Cependant, les pertes d'insertion de part et d'autre de cette pointe de résonance présentent un recul relativement faible par rapport au sommet de la pointe de résonance. Ceci résulte d'un découplage insuffisant entre les microrubans pour les fréquences qui s'écartent de la fréquence de résonance.

Pour obtenir un recul des pertes d'insertion, le couplage des deux résonateurs est assuré par un réseau de réflexion dont les traits sont disposés obliquement par rapport aux axes des résonateurs tel que celui décrit dans l'article « Planar Technology readies challange to YIG spheres » de Robert J. Gallagher publié dans la revue Electronics du 13 janvier 1983, pages 85 et 86. L'espacement des traits du réseau de réflexion est choisi de façon à renvoyer le maximum d'énergie d'un résonateur vers l'autre à la longueur d'onde désirée.

Néanmoins, on constate que la fonction de transfert globale peut présenter au voisinage de la pointe de résonance destinée à assurer le fonctionnement monomode, des signaux parasites correspondant à d'autres modes longitudinaux des résonateurs.

L'invention a pour objet un dispositif sélectif accordable à ondes magnétostatiques de volume comportant une couche magnétique dans laquelle est formé au moins un résonateur à réseaux réflecteurs associé à un réseau réflecteur de renvoi extérieur au résonateur et comportant des sillons gravés dans la couche magnétique, ledit réseau réflecteur de renvoi assurant la transmission, par réflexion d'ondes magnétostatiques provenant dudit résonateur à réseaux réflecteurs, lequel crée outre un mode longitudinal désiré, d'autres modes longitudinaux qui l'encadrent, caractérisé en ce que la profondeur des sillons et le nombre de sillons du réseau réflecteur sont tels que les ondes magnétostatiques puissent être réfléchies par chacun des sillons, le temps de traversée dudit réseau de renvoi par les ondes magnétostatiques ayant pour inverse une bande passante de référence ; ladite bande passante étant centrée sur ledit mode longitudinal désiré et suffisamment étroite pour exclure lesdits autres modes longitudinaux.

L'invention sera mieux comprise au moyen de la description ci-après et des figures annexées parmi lesquelles :

— la figure 1 est une vue isométrique d'un dispositif sélectif accordable à ondes magnétostatiques de type connu ;

— la figure 2 est une coupe du dispositif de la figure 1 ;

— la figure 3 est une courbe de réponse en fréquence du dispositif des figures 1 et 2 ;

— la figure 4 représente en fonction de la profondeur relative des sillons, des courbes donnant la bande passante à demi-puissance de réseaux réflecteurs comportant respectivement 10, 20 et 48 traits ;

— la figure 5 représente, en fonction de la profondeur relative des sillons, des courbes donnant l'indice de réflexion de réseaux réflecteurs comportant 10, 20 et 66 traits ;

— la figure 6 est une courbe de réponse en fréquences du dispositif selon l'invention ;

— la figure 7 représente un schéma explicatif d'une variante de réalisation de l'invention.

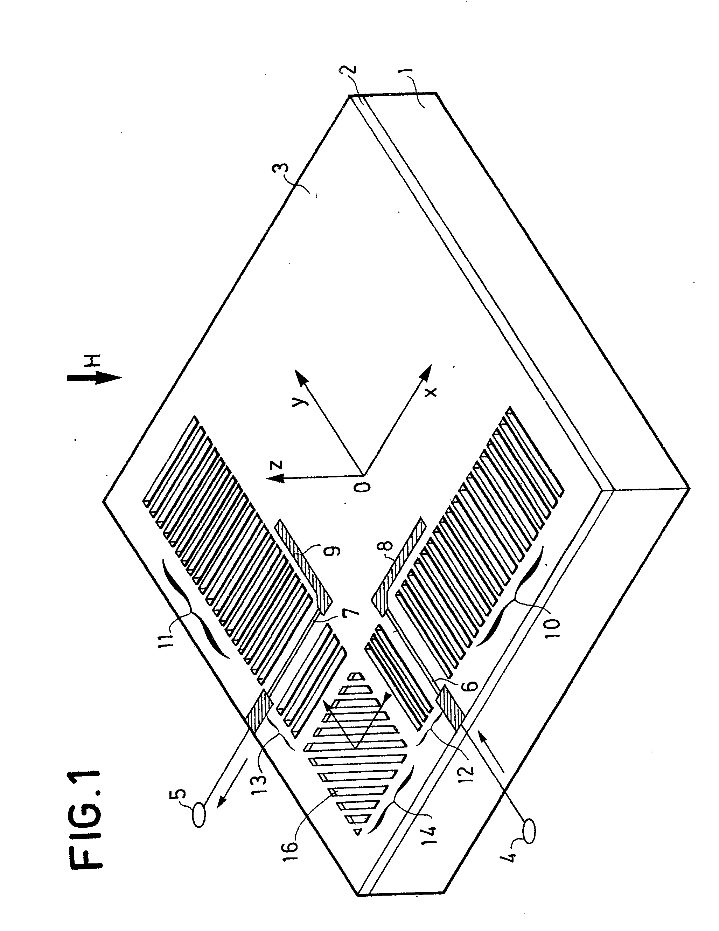

Sur la figure 1, on peut voir un résonateur à deux portes 4 et 5 basé sur l'excitation et la captation d'ondes magnétiques.

Ce dispositif se compose par exemple d'un substrat non magnétique 1 en grenat de gadolinium et gallium (GGG) à la surface duquel a été déposée par épitaxie en phase liquide une couche magnétique 2 de grenat d'yttrium et de fer (YIG). Un repère trirectangulaire Oxyz est représenté sur la figure 1 avec son plan Oxy parallèle à la surface libre de la couche 2. L'épaisseur de la couche magnétique 2 est typiquement de 23 microns. Des moyens magnétiques inducteurs non représentés sur la figure 1 soumettent la couche magnétique 2 à un champ magnétique de polarisation H de direction parallèle à

**0 128 798**

l'axe Oz.

Dans ces conditions, on sait que la couche 2 peut servir de milieu de propagation d'ondes magnétostatiques de volume progressives (OMVF). Les caractéristiques de ces ondes sont les mêmes pour toutes les directions du plan xOy et elles dépendent de l'intensité du champ magnétique de polarisation.

Dans la couche magnétique 2 ont été pratiqués, par exemple par usinage ionique, des sillons dont le rôle est de créer des ruptures d'impédance destinées à réfléchir les ondes magnétostatiques. On a ainsi créé cinq réseaux de réflexion 10, 11, 12, 13 et 14. Les traits des réseaux 10 et 12 sont disposés sur la couche magnétique 2 perpendiculairement à l'axe Ox, les traits du réseau 14, selon la bissectrice extérieure de l'angle xOy.

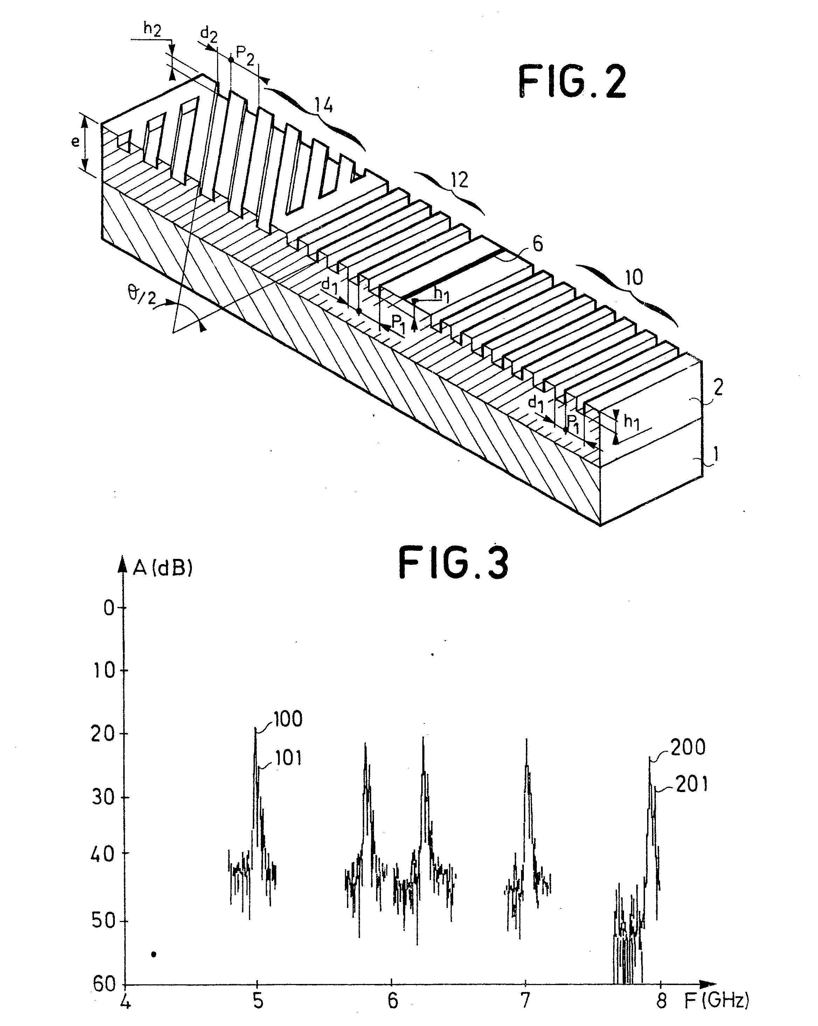

La figure 2 représente une tranche du dispositif de la figure 1, découpée sensiblement selon l'axe Ox parallèlement au plan zOx. Cette figure met en évidence la constitution des réseaux 10, 12 et 14. Les réseaux 11 et 13 de la figure 1 sont identiques respectivement aux réseaux 10 et 12. On se contentera donc de ne décrire que ces derniers et le réseau 14.

Les réseaux 10 et 12 sont constitués de sillons identiques de largeur d1, de pas p1 et de profondeur relative h1/e, h1 étant la profondeur des sillons et e l'épaisseur de la couche magnétique 2.

Le pas p1 est choisi en fonction de la longueur $\lambda$ des ondes magnétostatiques. Pour une valeur $\lambda_0$, chaque réseau présente globalement la réflectivité maximale si $2p1 = k\lambda_0$ avec k = 1, 2, 3, ... La largeur d1 d'un trait de réseau fixe le rapport d1/p1. On peut agir sur ce rapport pour amoindrir la réflectivité du réseau à une longueur d'onde sous-multiple de celle pour laquelle la réflectivité maximale est recherchée.

Dans le cas de la figure 1, on peut par exemple supposer que $p1 = \lambda_0/2$, ce qui revient à s'imposer une fréquence d'onde magnétostatique $f_{(H)}$ pour chaque intensité du champ magnétique H de polarisation de la couche 2.

Les réseaux 10 et 12 délimitent un résonateur dans lequel un microruban 6 est déposé par métallisation sur la surface de la couche 2. Comme on peut le voir sur la figure 1, le microruban 6 est relié, d'une part, à une métallisation 8 constituant une charge électrique d'extrémité et, d'autre part, à la connexion d'entrée 4.

Les deux résonateurs constitués par les réseaux 10, 12 d'une part, et 11, 13 d'autre part, sont agencées de telle façon que leurs axes, respectivement parallèles à Ox et Oy, se recoupent dans une région où s'étend le réseau 14.

Le réseau 14 est formé de sillons rectilignes parallèles à la bissectrice extérieure de l'angle xOy. L'angle xOy n'a nul besoin d'être un angle droit. L'angle formé par les sillons des réseaux 14 et 12 est $\theta/2$.

Le pas p2 des sillons du réseau 14 est donné par la relation :

$$p2 = \frac{\lambda}{2 \cos \theta/2}$$

La largeur des sillons est d2 et la profondeur h2.

Le microruban 6 est parcouru par un courant haute fréquence reçu sur sa connexion d'entrée 4. Il engendre l'émission d'ondes magnétostatiques à front d'ondes rectilignes perpendiculaires à l'axe Ox. Les réseaux 10 et 12 réfléchissent ces ondes magnétostatiques. Le réseau 10 est à réflexion presque totale et le réseau 12 à réflexion partielle. Une partie de l'énergie qui émerge du résonateur 10, 12 est réfléchie par le réseau 14 vers le résonateur 11, 13. Le réseau 11 est à réflexion presque totale et le réseau 13 partiellement réflecteur. Le conducteur 7 est le siège d'un courant électrique dont l'intensité est maximale pour une longueur d'onde déterminée caractérisant le fonctionnement des résonateurs.

Le réseau 14 est conçu pour réfléchir le mieux possible les ondes qui émergent du réseau 12, pour les renvoyer vers le réseau 13, de façon à définir une pointe de résonance avec une perte d'insertion minimale en son centre. Lorsque la longueur d'onde des ondes magnétostatiques s'éloigne de cette valeur centrale, le réseau 14 réalise un découplage efficace des cavités de résonance 10-12 et 11-13.

Un tel dispositif sera gravé dans une couche magnétique d'épaisseur e relativement faible, comprise entre 10 et 30 $\mu$m. En effet, la vitesse de groupe des ondes magnétostatiques de volume dépend de l'épaisseur de la couche magnétique de propagation qui sera donc choisie faible. Pour d'autres raisons qui résident dans des problèmes d'adaptation d'impédance des transducteurs, dans des conditions d'épitaxie et des problèmes de pertes, on a également intérêt à avoir une épaisseur de la couche magnétique réduite.

On prendra donc à titre d'exemple, un dispositif dont l'épaisseur de la couche magnétique sera e = 23 $\mu$m, avec des réseaux accordés à une longueur $\lambda$ = 150 $\mu$m, soit des pas de sillons p1 = 75,5 $\mu$m pour les réseaux 10 à 13. Si les cavités 10-12 et 11-13 sont orientées perpendiculairement ($\theta$ = 90°), le pas des sillons du réseau 14 sera de p2 = 106,1 $\mu$m. La profondeur relative des sillons, h1/e pour les réseaux des cavités résonnantes et h2/e pour le réseau réflecteur, sera prise égale à 1,5 %. Par ailleurs, dans une couche magnétique de 23 $\mu$m d'épaisseur, à une fréquence de 3 GHz et à une longueur d'onde $\lambda$ = 150 $\mu$m, la vitesse de groupe des ondes magnétostatiques de volume est v = 72,5 km/s.

Les courbes de réponses de ce dispositif sont fournies en figure 3 pour différentes valeurs de fréquences correspondant à différentes valeurs du champ de polarisation. En abscisses on a porté les valeurs F des fréquences en GHz et en ordonnées, les valeurs A des pertes d'insertion en dB.

3

A la valeur de fréquence 5 GHz on constate une pointe de résonance 100 avec de part et d'autre des pertes d'insertion accrues. Cependant, il existe juste à côté de la pointe de résonance 100, une pointe parasite 101.

A la valeur de fréquence voisine de 8 GHz on voit également une pointe de résonance 200 et un mode parasite 201. Il en est de même pour les autres fréquences.

Ces signaux parasites correspondent à des modes longitudinaux des deux cavités couplées 10-12 et 11-13. L'écart entre un mode parasite le plus proche et la fréquence de résonance a pour expression :

$$\Delta f = \frac{v}{2\,L}$$

dans laquelle v est la vitesse de groupe des ondes magnétostatiques à la longueur d'onde d'accord des résonateurs et L la longueur équivalente de chaque cavité.

Dans le cas observé, on a trouvé $\Delta f = 27$ MHz.

Pour les différentes applications des résonateurs à ondes magnétostatiques telles que les filtres ou les oscillateurs hyperfréquences accordables, il est nécessaire que ces composants aient un fonctionnement monomode.

L'objet de la présente invention est donc de combattre les modes parasites longitudinaux les plus proches du mode longitudinal correspondant au fonctionnement monomode désiré. Pour celà, l'invention prévoit une fenêtre de largeur $\Delta f_0$ en dehors de laquelle les pertes d'insertion sont augmentées et définit la valeur $\Delta f_0$ de telle façon qu'elle soit inférieure à l'écart $\Delta f$ entre le mode longitudinal désiré et les autres modes. La définition de cette fenêtre est faite à travers l'étude de la constitution du réseau réflecteur 14 en ce qui concerne la profondeur des sillons et le nombre de sillons.

On précise tout d'abord qu'on appelle bande passante $\Delta f_0$ la bande passante de référence correspondant à l'inverse du temps de transmission sous le réseau réflecteur 14, c'est-à-dire $\Delta f_0 = 1/T$. Cette bande passante est, par ailleurs, le double de la bande passante $\delta f$ à mi-hauteur de la puissance ($\Delta f_0 = 2 \cdot \delta f$).

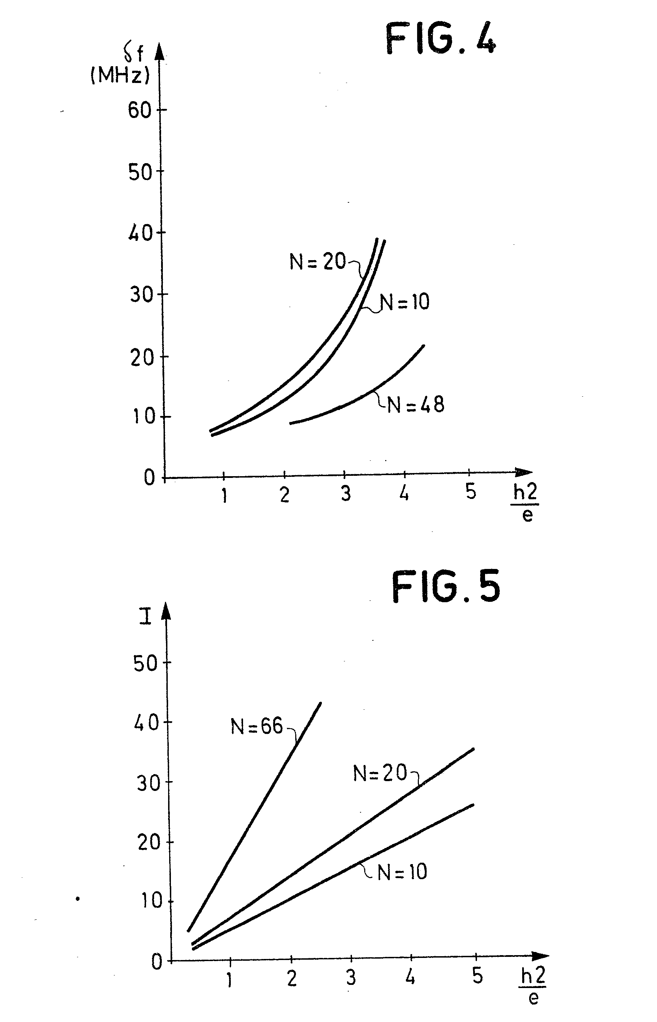

Sur un réseau du type du réseau 14, on mesure donc en réflexion à incidence normale la bande passante à mi-hauteur en fonction de la profondeur relative des sillons. La figure 4 fournit des courbes relevées à une fréquence de 3 GHz et à une longueur d'onde magnétostatique $\lambda = 300$ μm. En abscisse on a porté les profondeurs relatives des sillons h2/e et en ordonnées, la bande passante $\delta f$ à mi-hauteur (en MHz). Ces courbes ont été relevées pour différentes valeurs du nombre N de sillons (N = 48, N = 10, N = 20).

On s'aperçoit sur ces courbes que la bande passante à mi-hauteur diminue lorsque la profondeur relative des sillons diminue. Il en est a fortiori de même pour la bande passante de référence $\Delta f_0$.

Si on applique les résultats de ces courbes au réseau réflecteur décrit précédemment avec le nombre de sillons N = 20, h2/e = 1,5 % et $\lambda = 300$ μm, on trouve sur la courbe N = 20, une bande passante à mi-hauteur $\delta f = 11,5$ MHz. La bande passante de réflexion est donc $\Delta f_0 = 23$ MHz.

Pour extrapoler ces résultats au cas d'un fonctionnement du réseau réflecteur à la longueur d'onde $\lambda = 150$ μm, on adopte la procédure suivante.

Si T est le retard sous le réseau, on a vu que $\Delta f_0 = 1/T$. Par ailleurs on a $T = 1/v$ où 1 est proportionnel à la longueur du réseau et v est proportionnel à la vitesse de groupe. Enfin, 1 à la longueur d'onde $\lambda = 150$ μm est la moitié de 1 à la longueur d'onde $\lambda = 300$ μm soit : $1_{(\lambda = 150\ \mu m)} = \Delta \cdot 1_{(\lambda = 300\ \mu m)}$.

En appliquant la formule $\Delta f_0 = v/1$ aux longueurs d'ondes 150 μm et 300 μm on obtient la bande passante de référence à la longueur d'onde 150 μm =

$$\Delta f_{0_{(\lambda = 150\ \mu m)}} = 2\,\frac{v_{g_{(\lambda = 150\ \mu m)}}}{v_{g_{(\lambda = 300\ \mu m)}}}\,\Delta f_{0_{(\lambda = 300\ \mu m)}}$$

Dans cette expression, la vitesse de groupe à la longueur d'onde $\lambda = 150$ μm est $v_{g(\lambda = 150\ \mu m)} = 72,5$ km/s ; la vitesse de groupe à la longueur d'onde $\lambda = 300$ μm est $v_{g(\lambda = 300\ \mu m)} = 109,4$ km/s. Dans ces conditions, ayant trouvé la bande passante de référence à la longueur d'onde $\lambda = 300$ μm, $\Delta f_{0(\lambda = 300\ \mu m)} = 23$ MHz ; on trouve la bande passante de référence à la longueur d'onde $\lambda = 150$ μm :

$$\Delta F_{0_{(\lambda = 150\ \mu m)}} = 30,5\ \text{MHz}\,.$$

L'écart entre la résonance et le mode parasite longitudinal le plus proche ayant été trouvé égal à 27 MHz.

Cette étude confirme donc qu'il est normal de voir apparaître à un niveau non négligeable, sur les courbes de la figure 3, les modes tels que les modes 101 et 201.

De même, les résultats de ces études vont nous permettre par un raisonnement inverse de déterminer la profondeur des sillons à prévoir pour éliminer les modes parasites longitudinaux.

Pour cela nous choisissons, à la longueur d'onde $\lambda = 150$ μm, une bande passante de référence inférieure à 27 MHz, soit 24 MHz par exemple. L'application des calculs précédents nous donne la bande passante de référence à la longueur d'onde $\lambda = 300$ μm de $\Delta f_{0(\lambda = 300\ \mu m)} = 18$ MHz. Ce qui donne une bande passante à mi-hauteur de $\Delta f_{(\lambda = 300\ \mu m)} = 9$ MHz. En se reportant aux courbes de la figure 3 on trouve pour un réseau réflecteur 14 comportant 20 sillons, une profondeur de sillons h2/e = 1 %.

Par ailleurs une étude, toujours en réflexion perpendiculaire sur le nombre de sillons constituant le réseau 14 montre que pour une profondeur de sillons donnée, l'indice de réflexion augmente avec le nombre de sillons.

La figure 5 fournit un réseau de courbes relevées à une fréquence de 3 GHz et à $\lambda = 300\ \mu m$. En abscisses on a porté les profondeurs relatives des sillons h2/e et en ordonnées des indices de réflexion I. Ces courbes ont été relevées pour différentes valeurs du nombre de sillons (N = 10, N = 20, N = 66).

Le coefficient de réflexion se calcule à partir de l'indice de réflexion à l'aide de la formule :

$$(R)^2 = 1 - 10^{-1/10}$$

Pour un indice de réflexion I = 20, on aura donc un coefficient de réflexion de R = 0,995. Pour un indice de réflexion I = 10, on aura un coefficient de réflexion de R = 0,95.

Il apparaît donc que pour une profondeur relative de sillons donnée on a intérêt à prévoir un nombre de sillons élevés.

Dans l'application numérique précédente, il conviendra, par exemple, de choisir dans le réseau de courbes, pour une profondeur relative de sillons de 1 %, un nombre de sillons voisin de N = 40.

Un dispositif selon l'invention semblable à celui décrit précédemment a été gravé avec pour épaisseur de la couche magnétique e = 19 $\mu m$, une profondeur relative des sillons des réseaux R10, R11, R12, R13, h1/e = 1,37 %, une profondeur relative des sillons du réseau R14, h2/e = 1,1 %.

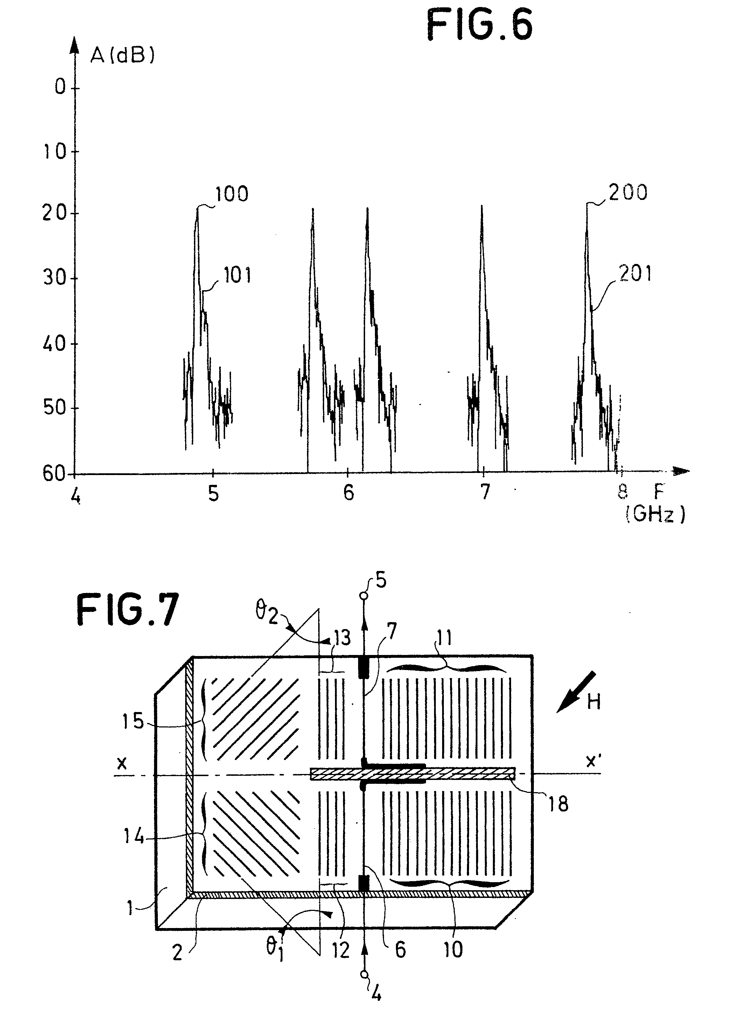

Le fonctionnement de ce dispositif, à une longueur d'onde $\lambda = 150\ \mu m$, donne les courbes de réponses en fréquences de la figure 6. En comparant ces courbes à celles de la figure 3, on constate un affaiblissement appréciable des modes parasites longitudinaux les plus proches des fréquences de résonance telles que 101 et 201, cela sans augmentation notable des pertes du mode principal.

De plus, on constate que plus la fréquence est élevée plus la réjection, c'est-à-dire la différence entre les pertes de la résonance principale et celle du mode parasite longitudinal est importante. Ainsi, à 5 GHz, la réjection passe de 5 dB (voir figure 3) à 13 dB (voir figure 6). Tandis qu'au voisinage de 8 GHz, la réjection passe de 5 dB (voir figure 3) à 16 dB (voir figure 6).

En se reportant à la figure 7, on va maintenant décrire un exemple d'une variante de réalisation du dispositif selon l'invention.

Selon cette variante les deux résonateurs 10-12 et 11-13 sont disposés côte à côte symétriquement par rapport à un axe xx'. Ils sont séparés par une zone absorbante 18 dont la structure cristalline de la couche magnétique 2 a été désorganisée par sablage et qui découple les deux résonateurs.

Un premier réseau réflecteur 14 est disposé à la sortie du réseau 12. Les sillons de ce réseau 14 forment un angle $\theta_1$ avec les sillons des réseaux 10 et 12.

Un deuxième réseau réflecteur 15, identique au réseau 14, disposé à la sortie du réseau 13, de façon à recevoir par ailleurs les ondes réfléchies par le réseau 14. Les sillons de ce réseau 15 forment un angle $\theta_2$ avec les sillons des réseaux 11 et 13.

Par ailleurs, dans la mesure où les résonateurs 10-12 et 11-13 sont rigoureusement parallèles, les sillons des réseaux 14 et 15 doivent être perpendiculaires. On prendra avantageusement $\theta_1 = \theta_2 = 45°$ pour avoir une structure symétrique du dispositif.

Une telle disposition présente l'avantage d'être plus compacte, de permettre une fabrication identique donc plus aisée des résonateurs 10-12 et 11-13, et de prévoir un champ magnétique de polarisation H uniforme et identique pour les deux unités.

De plus, l'affaiblissement des modes parasites longitudinaux obtenu par la conception du réseau réflecteur 14 sera augmenté par la présence du deuxième réseau réflecteur 15 de conception identique au précédent.

Une autre amélioration du réseau réflecteur 14 et, par suite ; également du réseau 15 consiste à prévoir la largeur d2 des sillons égale à l'espace entre sillons, c'est-à-dire à avoir d2 = p2/2. De cette façon on élimine le mode relatif à la résonance correspondant à la longueur d'ondes $\lambda/2$.

**Revendications**

1. Dispositif sélectif accordable à ondes magnétostatiques de volume comportant une couche magnétique dans laquelle est formée au moins un résonateur à réseaux réflecteurs (10-12) associé à un réseau réflecteur de renvoi (14) extérieur au résonateur (10-12) et comportant des sillons gravés dans la couche magnétique (2), ledit réseau réflecteur de renvoi (14) assurant la transmission, par réflexion, d'ondes magnétostatiques provenant dudit résonateur à réseaux réflecteurs (10-12), lequel crée outre un mode longitudinal désiré, d'autres modes longitudinaux qui l'encadrent, caractérisé en ce que la profondeur des sillons et le nombre de sillons du réseau réflecteur de renvoi (14) sont tels que les ondes magnétostatiques puissent être réfléchies par chacun des sillons, le temps de traversée dudit réseau de renvoi (14) par les ondes magnétostatiques ayant pour inverse une bande passante de référence ; ladite bande passante étant centrée sur ledit mode longitudinal désiré et suffisamment étroite pour exclure lesdits autres modes longitudinaux.

2. Dispositif sélectif accordable à ondes magnétostatiques de volume selon la revendication 1, caractérisé en ce que la profondeur (h2) des sillons du réseau réflecteur de renvoi (14) est ajustée pour assurer un renvoi d'énergie substantiel pour chacun des sillons dudit réseau de renvoi (14).

3. Dispositif sélectif accordable à ondes magnétostatiques de volume selon la revendication 2, caractérisé en ce que la profondeur relative (h2/e) des sillons du réseau réflecteur de renvoi (14) est choisie à une valeur voisine de 1 % de l'épaisseur (e) de la couche magnétique (2) pour une longueur d'onde magnétostatique de 300 microns.

4. Dispositif sélectif accordable à ondes magnétostatiques du volume selon la revendication 2, caractérisé en ce que le nombre (N) de sillons du réseau réflecteur de renvoi (14) a été choisi, en relation avec la profondeur des sillons ; à une valeur telle que les propriétés de réflexion du réseau réflecteur de renvoi (14) soient conservées pour l'ensemble de ses traits.

5. Dispositif sélectif accordable à ondes magnétostatiques de volume selon la revendication 1, caractérisé en ce que la largeur (d2) des sillons du réseau réflecteur (14) est égal à l'espace entre sillons.

6. Dispositif sélectif accordable à ondes magnétostatiques de volume selon les revendications 3 et 4 comprenant une première cavité résonnante (10, 12) et un premier réseau réflecteur (14), caractérisé en ce qu'il comprend également un deuxième réseau réflecteur (15) et une deuxième cavité résonnante (11, 13) voisine de la première cavité résonnante (10, 12), le deuxième réseau réflecteur (15) étant orienté de façon à recevoir les ondes magnétostatiques réfléchies par le premier réseau réflecteur (14) et à les renvoyer vers la deuxième cavité résonnante (11, 13).

7. Dispositif sélectif accordable à ondes magnétostatiques de volume selon la revendication 6, caractérisé par le fait que les deux cavités résonnantes (10, 12 et 11, 13) ont des structures parallèles, sont accolées, et que les sillons des deux réseaux réflecteurs (14 et 15) sont orientés selon deux directions perpendiculaires.

8. Dispositif sélectif accordable à ondes magnétostatiques de volume selon la revendication 7, caractérisé en ce que les deux cavités résonnantes (10, 12 et 11, 13) sont découplées par une zone absorbante.

**Claims**

1. A selective tunable magnetostatic volume wave device comprising a magnetic layer in which at least one reflector grating resonator (10 to 12) is formed, this resonator being associated to a reflector grating (14) which is outside the resonator (10 to 12), the device further comprising grooves engraved in the magnetic layer (2), the reflector grating (14) ensuring the transmission by reflection of magnetostatic waves coming from said reflector grating resonator (10 to 12) which produces besides a desired longitudinal mode other longitudinal modes on both sides thereof, characterized in that the depth of the grooves and the number of grooves of the reflector grating (14) are chosen so that the magnetostatic waves may be reflected by any one of the grooves, the time of passage of the magnetostatic waves through this reflector grating (14) being inversely correlated to a reference pass band, said pass band being centered on said desired longitudinal mode and being sufficiently small for excluding said other longitudinal modes.

2. A selective tunable magnetostatic volume wave device according to claim 1, characterized in that the depth (h2) of the grooves of said reflector grating (14) is adjusted in order to ensure a substantial energy reflection for each one of the grooves of said reflector grating (14).

3. A selective tunable magnetostatic volume wave device according to claim 2, characterized in that the relative depth (h2/e) of the grooves of the reflector grating (14) is chosen to be close to 1 % of the thickness (e) of the magnetic layer (2) for a magnetostatic wave length of 300 micrometer.

4. A selective tunable magnetostatic volume wave device according to claim 2, characterized in that the number (N) of grooves of the reflector grating (14) has been chosen in relation with the depth of the grooves such that the reflection properties of the reflector grating (14) remain unchanged for the entire assembly of its lines.

5. A selective tunable magnetostatic volume wave device according to claim 1, characterized in that the width (d2) of the grooves of the reflector grating (14) is equal to the interspace between grooves.

6. A selective tunable magnetostatic volume wave device according to claims 3 and 4, comprising a first resonance cavity (10, 12) and a first reflector grating (14), characterized in that it further comprises a second reflector grating (15) and a second resonance cavity (11, 13) situated close to the first resonance cavity (10, 12), the second reflector grating (15) being directed so as to receive the magnetostatic waves after their reflection by the first reflector grating (14) and as to reflect them towards the second resonance cavity (11, 13).

7. A selective tunable magnetostatic volume wave device according to claim 6, characterized in that the two resonance cavities (10, 12 and 11, 13) have parallel structures and are located close to each other and that the grooves of both reflector gratings (14 and 15) are directed according to two perpendicular directions ;

8. A selective tunable magnetostatic volume wave device according to claim 7, characterized in that

6

the two resonance cavities (10, 12 and 11, 13) are discoupled by an absorbing zone.

**Patentansprüche**

1. Selektiv abstimmbare magnetostatische Raumwellenvorrichtung, mit einer magnetischen Schicht, in der mindestens ein Reflektorgitter (10 bis 12) enthaltender Resonator ausgebildet ist, der einem Umlenkreflektorgitter (14) außerhalb des Resonators (10 bis 12) zugeordnet ist, und mit Rillen, die in die Magnetschicht (2) eingraviert sind, wobei das Umlenkreflektorgitter (14) die Übertragung von magnetostatischen Wellen von dem Resonator mit Reflektorgittern (10 bis 12) aufgrund einer Reflexion bewirkt, wobei der Resonator außer einem erwünschten Längsmodus andere diesen umrahmende Längsmodi erzeugt, dadurch gekennzeichnet, daß die Tiefe und die Anzahl der Rillen des Umlenkreflektorgitters (14) so gewählt sind, daß die magnetostatischen Wellen von jeder der Rillen reflektiert werden können, wobei die Zeit, die die magnetostatischen Wellen zum Durchlaufen des Umlenkgitters (14) brauchen, dem Inversen eines Bezugs-Durchlaßbandes entspricht, das auf den erwünschten Längsmodus zentriert und hinreichend schmal ist, um die anderen Längsmodi auszuschließen.

2. Selektiv abstimmbare magnetostatische Raumwellenvorrichtung nach Anspruch 1, dadurch gekennzeichnet, daß die Tiefe (h2) der Rillen des Umlenkreflektorgitters (14) so gewählt ist, daß eine wesentliche Energieumlenkung für jede der Rillen dieses Umlenkgitters (14) bewirkt wird.

3. Selektiv abstimmbare magnetostatische Raumwellenvorrichtung nach Anspruch 2, dadurch gekennzeichnet, daß die relative Tiefe (h2/e) der Rillen des Umlenkreflektorgitters (14) auf einen Wert in der Nähe von 1 % der Dicke (e) der magnetischen Schicht (2) für eine Wellenlänge der magnetostatischen Wellen von 300 Mikrometer gewählt ist.

4. Selektiv abstimmbare magnetostatische Raumwellenvorrichtung nach Anspruch 2, dadurch gekennzeichnet, daß die Anzahl (N) von Rillen des Umlenkreflektorgitters (14) bezüglich der Tiefe der Rillen auf einen solchen Wert festgelegt wurde, daß die Reflexionseigenschaften des Umlenkreflektorgitters (14) für die Gesamtheit ihrer Striche erhalten bleibt.

5. Selektiv abstimmbare magnetostatische Raumwellenvorrichtung nach Anspruch 1, dadurch gekennzeichnet, daß die Breite (d2) der Rillen des Reflektorgitters (14) gleich dem Abstand zwischen Rillen ist.

6. Selektiv abstimmbare magnetostatische Raumwellenvorrichtung nach den Ansprüchen 3 und 4 mit einem ersten Resonanzhohlraum (10, 12) und einer ersten Reflektorgitter (14), dadurch gekennzeichnet, daß sie außerdem ein zweites Reflektorgitter (15) und einen zweiten Resonanzhohlraum (11, 13) in der Nähe des ersten Resonanzhohlraums (10, 12) enthält, wobei das zweite Reflektorgitter (15) so ausgerichtet ist, daß es die vom ersten Reflektorgitter (14) reflektierten magnetostatischen Wellen empfängt und zum zweiten Resonanzhohlraum (11, 13) umlenkt.

7. Selektiv abstimmbare magnetostatische Raumwellenanordnung nach Anspruch 6, dadurch gekennzeichnet, daß die beiden Resonanzhohlräume (10, 12 und 11, 13) parallele Strukturen besitzen und aneinander anschließen, und daß die Rillen der beiden Reflektorgitter (14 und 15) gemäß zwei zueinander senkrechten Richtungen ausgerichtet sind.

8. Selektiv abstimmbare magnetostatische Raumwellenanordnung nach Anspruch 7, dadurch gekennzeichnet, daß die beiden Resonanzhohlräume (10, 12 und 11, 13) durch eine Absorptionszone entkoppelt sind.

# FIG.1

0 128 798

# FIG.2

# FIG.3

# FIG. 4

# FIG. 5

# FIG.6

# FIG.7